# EUROPÄISCHE PATENTSCHRIFT

(11) **EP 1 468 496 B1**
(45) Veröffentlichungstag und Bekanntmachung des Hinweises auf die Patenterteilung: **08.03.2006**
(21) Anmeldenummer: 02795095.5
(22) Anmeldetag: 04.12.2002
(51) Int. Cl.: H03M 1/30

(54) **VERFAHREN ZUR INTERPOLATION MINDESTENS ZWEIER POSITIONSABHÄNGIGER, PERIODISCHER, ZUEINANDER PHASENVERSCHOBENER ANALOGSIGNALE**
METHOD FOR INTERPOLATING AT LEAST TWO POSITION-DEPENDENT, PERIODIC ANALOG SIGNALS THAT ARE DEPHASED RELATIVE EACH OTHER
PROCEDE D'INTERPOLATION D'AU MOINS DEUX SIGNAUX ANALOGIQUES DEPENDANTS D'UNE POSITION, PERIODIQUES, DEPHASES L'UN PAR RAPPORT A L'AUTRE

(30) Priorität: 11.01.2002 DE 10201249; 27.02.2002 DE 10208915
(43) Veröffentlichungstag der Anmeldung: 20.10.2004
(73) Patentinhaber: Dr. Johannes Heidenhain GmbH, 83292 Traunreut (DE)
(72) Erfinder: WOYZICHOVSKI, Roman, 07751 Kunitz (DE)
(86) Internationale Anmeldenummer: PCT/EP2002/013702
(87) Internationale Veröffentlichungsnummer: WO 2003/058820

(56) Entgegenhaltungen:
- EP-A- 0 484 576
- EP-A- 0 599 175
- EP-A- 0 669 517
- EP-A- 0 874 223
- EP-A- 0 875 735
- EP-A- 0 997 701
- DE-A- 10 025 160
- DE-A- 19 502 276
- DE-A- 19 822 843
- DE-A- 19 934 478
- DE-A- 19 938 802
- US-A- 5 220 275
- US-A- 5 677 686

## Beschreibung

Die Erfindung betrifft ein Verfahren zur Interpolation mindestens zweier positionsabhängiger, periodischer und zueinander phasenverschobener Analogsignale nach dem Oberbegriff des Patentanspruchs 1.

Ein derartiges Verfahren dient dazu, Analogsignale, die durch Abtastung einer Meßteilung erzeugt werden, zur Positionsmessung, d.h. insbesondere zur Weg- und/oder Winkelmessung, zu interpolieren. Hierbei werden die Analogsignale mittels eines Sigma-Delta-Modulators jeweils in einen digitalen Datenstrom umgewandelt; die mindestens zwei Datenströme dann zur Erzeugung einer (einzelnen) Ergebnisfolge zunächst mit Korrekturfaktoren sowie anschließend miteinander verknüpft; und aus der Ergebnisfolge einerseits anhand eines (durch die Werte der Ergebnisfolge) zu erfüllenden Gütekriteriums neue Korrekturwerte und andererseits die Ausgangssignale der Interpolation erzeugt.

Die mindestens zwei Analogsignale sind insbesondere um 90° zueinander phasenverschoben und im wesentlichen sinusförmig, wobei Letzteres auch durch Phasenverschiebung aus der Sinusfunktion erzeugte Analogsignale, wie z. B. Kosinussignale, umfaßt.

Ein solches Verfahren ist aus der DE 199 38 802 A1 bekannt. Bei diesem Verfahren wird die Ergebnisfolge einem digitalen Filter zugeführt, der bestimmte Informationen der Eingangssignale restauriert, und anschließend in Abhängigkeit von dem Ausgangswert des Filters einen Phasenzähler inkrementiert oder dekrementiert. Der hierdurch erzeugte Phasenwert wird einerseits (bis zur Erfüllung des Gütekriteriums) zur Bestimmung neuer Korrekturwerte und andererseits zur Bestimmung des Ausgangssignales der Interpolation verwendet. Zur Erfüllung des Gütekriteriums erzeugt die Ergebnisfolge bei gleichzeitiger Dezimation in einem Filter eine Signalfolge, die nach Vergleich mit dem Gütekriterium die Korrekturwerte so steuert, daß die Ergebnisfolge sich diesem Gütekriterium nähert und zum anderen eine Adressfolge gebildet wird, aus der nach Tiefpaßfilterung und Zuordnung die Ausgangssignale erzeugt werden.

Aus der DE 195 02 276 A1 ist ein Interpolationsverfahren zum Interpolieren mindestens zweier durch Abtastung eines Teilungsträgers gewonnener, positionsabhängiger, periodischer und um 90° zueinander phasenverschobener sinusähnlicher Analogsignale zum Messen von Wegen und/oder Winkeln bekannt, bei dem den Analogsignalen jeweils mittels Sigma-Delta-Modulation ein Rauschen überlagert wird, bei dem aus den so entstandenen Datenfolgen unter gleichzeitiger erster unvollständiger Tiefpaßfilterung der Rauschanteile oberhalb der maximalen Eingangsfrequenz der Analogsignale Signalfolgen erzeugt werden und bei dem aus den Signalfolgen eine Folge von Winkelwerten gewonnen wird, der nach zweiter Tiefpaßfilterung des noch vorhandenen Rauschanteiles oberhalb der maximalen Eingangsfrequenz der Analogsignale eine Folge von Ausgangswerten zugeordnet wird.

Aus der DE 195 06 276 A1 ist ein Verfahren zur Interpolation von Sensorsignalen bekannt, bei dem je ein Sinus- und ein Kosinussignal eines Sensors einer Brückenschaltung mit mehreren Abgriffspunkten zugeführt wird und ein Wertevergleich zwischen einem Abgriffspaar, bestehend aus zwei Abgriffen, die in der Brückenschaltung diametral gegenüberliegen, durchgeführt wird. Bei Feststellung einer Wertegleichheit zwischen dem Abgriffspaar, die einem Nulldurchgang des Abtastwertes entspricht, wird ein die Stellung des entsprechenden Abgriffspaares repräsentierendes Signal ausgegeben. Dabei werden die Abgriffspaare in einer Richtung nacheinander abgetastet, nacheinander dem Wertevergleich unterzogen und jedem Abtastereignis ein Zählwert zugeordnet. Entsprechend dem Ergebnis des Vergleichs wird ein Phasenzähler inkrementiert oder dekrementiert.

Der Erfindung liegt das Problem zugrunde, ein Interpolationsverfahren der eingangs genannten Art weiter zu verbessern.

Dieses Problem wird erfindungsgemäß durch die Schaffung eines Verfahrens mit den Merkmalen des Patentanspruchs 1 gelöst.

Danach werden die Werte der Ergebnisfolge zur Erzeugung der Korrekturwerte sowie der Ausgangssignale über ein vorgebbares Zeitintervall akkumuliert und die durch Akkumulation erzeugte Signalfolge unmittelbar als Adressfolge zur Erzeugung der Korrekturwerte und des Ausgangssignales verwendet.

Zur Bildung einer Adressfolge wird also gemäß dem erfindungsgemäßen Verfahren nicht einfach ein Phasenzähler inkrementiert oder dekrementiert, sondern vielmehr durch Akkumulation ein Phasenwert mit fraktionalem Anteil erzeugt. Hierdurch werden eine genauere Phasennachführung, eine geringere Verstärkung der zur Erfüllung des Gütekriteriums verwendeten Regelschleife und somit eine verbesserte Dynamik des Gesamtsystems erreicht. Bei der Akkumulation über ein vorgegebenes Zeitintervall (Dezimation des Datenstromes) wird das Zeitintervall so gewählt, daß sich aus den akkumulierten Werten der Ergebnisfolge gerade die Phase der Analogsignale bestimmen läßt.

Die Akkumulation der Werte der Ergebnisfolge erfolgt vorzugsweise in einem Filter, und zwar insbesondere in einem Filter in Form eines Integrierers.

Die Adresswerte der durch Akkumulation gebildeten Adressfolge repräsentieren jeweils die Phaseninformation der eingangsseitigen Analogsignale und sind linear abhängig von der Phase mindestens eines der periodischen Analogsignale, wenn das Gütekriterium erfüllt ist. Das heißt, wenn die Erzeugung der Ausgangssignale soweit fortgeschritten ist, daß sich die Ergebnisfolge bzw. die hieraus erzeugte Adressfolge einem vorgegebenen Gütekriterium nähern, dann besteht ein linearer Zusammenhang zwischen den Adresswerten und der Phase der eingangsseitigen Analogsignale.

Aus der Adressfolge können schließlich durch Tiefpaßfilterung und anschließende Zuordnung der Adresswerte die Ausgangssignale der Interpolation erzeugt werden.

Gemäß der Erfindung repräsentieren die Adresswerte der Adressfolge einen Phasenwert mit fraktionalem Anteil, wobei zur Erzeugung der Korrekturwerte der hochwertige Teil der Adressfolge verwendet wird, der einem inkrementalen Anteil der Adressfolge entspricht, und zur Erzeugung der Ausgangssignale der Interpolation der hochwertige und der niederwertige Teil der Adressfolge verwendet werden. Letzterer entspricht dem fraktionalen Anteil der Adressfolge.

Der höherwertige Teil der Adressfolge ist so definiert, daß die Adresstiefe der Korrekturwerte die gewünschte Interpolation geweährlistet. Wenn z.B. die Periode eines sinusartigen eingangsseitigen Signales für die gewünschte Interpolation 32-fach unterteilt werden soll, dann muss der höherweitige Teil der Adressfolge eine Breite von 5 bit aufweisen. Der verbleibende, niederwertige Teil der Adressfolge bestimmt den fraktionalen Anteil eines Phaseninkrementes.

Insgesamt erfolgt die Bestimmung der Ausgangssignale der Interpolation rekursiv mittels einer Regelschleife, indem anhand des Gütekriteriums so lange neue Korrekturwerte erzeugt und mit den aus den eingangsseitigen Analogsignalen erzeugten digitalen Datenströmen verknüpft werden, bis das Gütekriterium erfüllt ist.

Die möglichen Korrekturwerte, bei denen es sich insbesondere um Werte trigonometrischer Funktionen (Sinus- und/oder Kosinusfunktionen) handeln kann, können als vorgegebene Werte in einer Zuordnungseinheit abgelegt sein. Aus den in der Zuordnungseinheit abgelegten Werten werden die jeweils mit den einzelnen Daten der digitalen Datenströme zu verknüpfenden Korrekturwerte anhand des Gütekriteriums in Abhängigkeit von den aktuellen Adresswerten der Adressfolge ausgewählt. Das Gütekriterium kann dabei wahlweise unmittelbar auf die Werte der Ergebnisfolge angewandt werden, indem dem zur Erzeugung der Adressfolge dienenden Filter (Integrierer) eine entsprechende Verknüpfungseinheit vorgeschaltet ist, oder diese Verknüpfungseinheit wird mit dem Filter (Integrierer) zu einer Einheit zusammengefaßt.

Zur Erzeugung der Ergebnisfolge werden die einzelnen Daten der aus den eingangsseitigen Analogsignalen erzeugten digitalen Datenströme jeweils multiplikativ mit einem Korrekturfaktor und anschließend die Daten unterschiedlicher Datenströme durch Addition oder Subtraktion miteinander verknüpft.

Der Sigma-Delta-Modulator ist vorzugsweise derart ausgelegt, daß die einzelnen Daten der hiermit erzeugten digitalen Datenströme jeweils eine Wortbreite von nur einem Bit aufweisen.

Bei exakter Phasenlage und sinusförmigem Verlauf der eingangsseitigen Analogsignale werden die Werte d der Ergebnisfolge gebildet nach der Formel d = s1*k1 +/- s2*k2, wobei s1, s2 Daten der mittels der Sigma-Delta-Modulation erzeugten digitalen Datenströme und k1, k2 zugeordnete Korrekturfaktoren sind. Die durch Akkumulation der Werte d der Ergebnisfolge erzeugte Adressfolge beeinflußt dabei die Korrekturwerte derart, daß ein linearer Zusammenhang zur Winkelinformation der eingangsseitigen Analogsignale hergestellt ist.

Wenn es sich bei den Daten der durch die Sigma-Delta-Modulation erzeugten Datenströme um Daten mit einer Wortbreite von einem Bit handelt, dann ergibt die Multiplikation s1*k1 bzw. s2*k2 die Werte k1 bei s1 = 1 und -k1 bei s1 = 0 bzw. k2 bei s2 = 1 und -k2 bei s2 = 0. Bei hinreichender Wortbreite der Korrekturwerte k1, k2 kann die Negation vereinfacht durch das Einser-Komplement erfolgen.

Da sich bei einer Wortbreite von einem Bit für die Daten der digitalen Datenströme als Ergebnis der vorstehend erläuterten Verknüpfung zur Erzeugung der Werte d der Ergebnisfolge genau vier Fälle unterscheiden lassen, kann die besagte Verknüpfung (arithmetische Operation) s1*k1 +/s2*k2 zusammengefaßt werden. Die vier Fälle lassen sich arithmetisch als Summe k1 + k2 der Korrekturwerte, Differenz k1 - k2 der Korrekturwerte sowie deren Negierte darstellen. Werden diese Differenzen und Summen als Korrekturwerte abgelegt, so reduziert sich der Aufwand für die arithmetischen Operationen weiter.

Eine digitale Interpolationseinrichtung zur Ausführung des erfindungsgemäßen Verfahrens ist durch die Merkmale des Patentanspruchs 20 charakterisiert.

Weitere Merkmale und Vorteile der Erfindung werden bei der nachfolgenden Beschreibung eines Ausführungsbeispiels anhand der Figur deutlich werden.

Es zeigt:

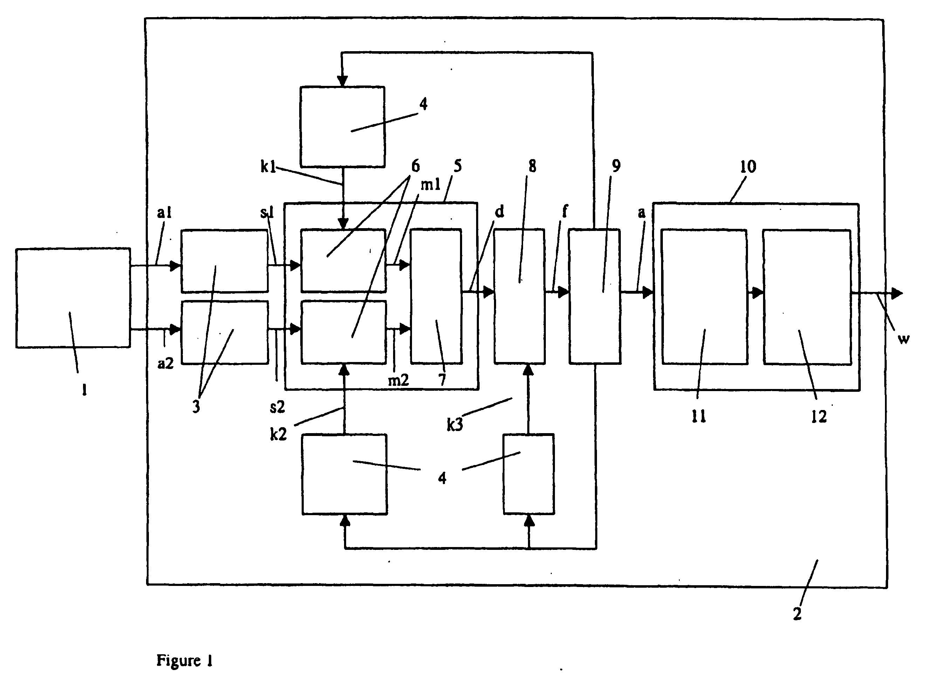

- Figur 1: eine schematische Darstellung einer Interpolationseinrichtung und des zugehörigen Interpolationsverfahrens zur Anwendung bei Positionsgebern zum Messen von Wegen und/oder Winkeln mittels eines Blockschaltbildes.

Ausgangspunkt des in Fig. 1 dargestellten Blockschaltbildes sind mindestens zwei in einem Positionsgeber 1 eines Meßsystems durch Abtastung gewonnene, positionsabhängige, periodische, zueinander um 90° phasenverschobene, sinusähnliche Analogsignale a1 und a2, die zum Messen von Wegen und/oder Winkeln verwendet sollen. Sie werden jeweils mittels Sigma-Delta-Modulation in einem Sigma-Delta-Modulator 3 in digitale Datenströme s1, s2 (Wortfolgen) hoher Frequenz und geringer Wortbreite gewandelt, bei denen in der zeitlichen Verteilung der Daten Amplitudeninformation enthalten ist. Die beiden Datenströme s1, s2 mit m-Bit breiten Daten entstehen demnach aus den Analogsignalen a1 und a2 jeweils durch Überlagerung mit einem Rauschsignal. Dieses Rauschsignal resultiert aus dem Quantisierungsrauschen der Sigma-Delta-Modulation.

Die Daten der digitalen Datenströme s1, s2 werden in einer Multiplikationseinheit 6 einer Arithmetikeinheit 5 jeweils multipliziert mit Korrekturwerten k1, k2 aus einer Zuordnungseinheit 4, in der eine vorgebbare Anzahl möglicher Korrekturwerte abgelegt ist. Aus den beiden durch Multiplikation der Daten mit den Korrekturwerten k1, k2 gebildeten neuen Folgen m1, m2 wird eine einzelne Ergebnisfolge d durch Addition bzw. Subtraktion der Worte jener Folgen m1, m2 in einer Additions-/Subtraktionseinheit 7 der Arithmetikeinheit 5 gebildet.

Die Werte der Ergebnisfolge d werden nach Verknüpfung mit einem Gütekriterium k3 aus der Zuordnungseinheit 4 in der Verknüpfungseinheit 8 einem Filter in Form einer Integriereinheit 9 zugeführt, in der sie zur Bildung einer Adressfolge a über einen vorgebbaren Zeitraum akkumuliert werden. Ein Teil (nämlich der höherwertige Teil) des in der Integriereinheit 9 akkumulierten Wertes wird wiederum verknüpft mit einem Wert aus der Zuordnungseinheit 4 und das Verknüpfungsergebnis dient unmittelbar der Adressierung zur Auswahl neuer Korrekturwerte k1, k2 aus der Zuordnungseinheit 4 für die Multiplikation mit den Daten der Sigma-Delta-Modulation. Alternativ kann die Verknüpfungseinheit 8 auch hinter dem Filter 9 angeordnet werden, wobei dann die Adressierung der Korrekturwerte in der Zuordnungseinheit 4 aus einem Teil des Ausgabewertes der nachgeordneten Einheit 8 erfolgt.

Falls das Gütekriterium ungleich Null ist, also die eingangsseitigen Analogsignale nicht sinus- bzw. cosinus-förmig sind, dann wird das Gütekriterium k3 in entsprechender Weise ermittelt wie vorstehend anhand der Korrekturwerte k1, k2 beschrieben.

Im abgeglichenen Zustand pendeln die Adressen der Adressfolge a zwischen diskreten Werten, die die beste Annäherung an den exakten Phasensollwert der Eingangssignale darstellen. Mit abschließender weiterer Filterung und Zuordnung in einer Auswerteschaltung 10, die einen digitales Tiefpaßfilter 11 und eine Zuordnungseinheit 12 umfaßt, wird das Ausgangssignal w der Interpolation gebildet.

Die Ausgabe des Ausgangssignales w erfolgt in Abhängigkeit von der Zuordnungseinheit in Form zweier zueinander um 90° phasenverschobener Rechtecksignale oder in einer beliebig anderen Form (binär, Graycode, ...).

Ähnlich wie bei Netzwerkinterpolatoren wird die Phaseninformation während der Wandlung gewonnen und es besteht ein linearer Zusammenhang zwischen der Änderung des Winkelwertes der eingangsseitigen Analogsignale a1 oder a2 und der Änderung des Ausgangswertes w.

Zur Realisierung des vorbeschriebenen Verfahrens wird eine digitale Interpolationseinrichtung verwendet.

Eingangssignale der Interpolationseinrichtung bilden zwei zueinander um 90° phasenverschobene, sinusähnliche Analogsignale a1 und a2, beispielsweise aus an sich bekannten inkrementellen Positionsgebern. Aus den beiden Analogsignalen a1 und a2 wird in der erfindungsgemäßen Interpolationseinrichtung 2 der Ausgangswert w mit der sich aus dem geforderten Interpolationsgrad ergebenden Auflösung gewonnen.

Zunächst werden die beiden Analogsignale a1 und a2 je einem Sigma-Delta-Modulator 3 zugeführt. Die Ausgangssignale der Sigma-Delta-Modulatoren 3, zwei digitale Datenströme s1, s2 mit Daten geringer Breite (z.B. 1-Bit breite Worte), werden in der Multiplikationseinheit 6 der Arithmetikeinheit 5 multipliziert mit je einem Korrekturwert k1, k2 der Zuordnungseinheit 4 und nach Addition bzw. Subtraktion der Folgen voneinander in der Additions-/Subtraktionseinheit 7 der Arithmetikeinheit 5 werden die Werte der Ergebnisfolge d dem Integrierer 9 zugeführt, dessen Ausgangssignal eine Adressfolge a aus Adresswerten ist.

Ein Teil der Adressfolge a wird außerdem verknüpft mit einem Wert aus der Zuordnungseinheit 4. Das Ergebnis der Verknüpfung bestimmt die Auswahl von Korrekturwerten aus der Zuordnungseinheit 4 derart, daß ein Gütekriterium k3 erreicht wird.

Die Adresswerte der Adressfolge a repräsentieren die gesuchte Phaseninformation beaufschlagt mit geringem Restrauschen. Anschließende Filterung der Adresswerte und Zuordnung bildet den interpolierten Ausgangswert w.

Die möglichen Korrekturwerte k1, k2, die in Abhängigkeit von dem aktuellen Adresswert ausgewählt werden, können in der Zuordnungseinheit 4 z.B. in Form einer Tabelle abgelegt wein. Handelt es sich bei den möglichen Korrekturwerten k1. k2 z.B. um Werte je einer trigonometrischen Funktion, so bedeutet dies, daß für eine bestimmte Anzahl an Punkten (z.B. für 16 Punkte) aus dem Wertebereich der entsprechenden trigonometrischen Funktion (z.B. einer sin- oder cos-Funktion) der jeweils zugehörige Funktionswert aus dem Wertebereich der trigonometrischen Funktion als ein möglicher Korrekturwert in der genannten Tabelle abgelegt wird.

Hierzu ein konkretes Beispiel: Werden die möglichen Werte des einen Korrekturwertes k1 als Funktionswerte einer cos-Funktion bestimmt, so wird demgemäß für 16 Punkte aus dem Definitionsbereich (0° - 360°) der cos-Funktion der jeweils zugehörige Funktionswert (z.B. der Funktionswert cos0°=1 für den Wert 0° des Definitionsbereiches, der Funktionswert cos22,5° für den Wert 22,5° des Definitionsbereiches, der Funktionswert cos45° für den Wert 45° des Definitionsbereiches usw.) als möglicher Wert des Korrekturwertes k1 in der dafür vorgesehenen Tabelle abgelegt. Aus diesen 16 in der Tabelle abgelegten Funktionswerten wird dann der jeweilige Korrekturwert k1 ausgewählt. Der andere Korrekturwert k2 kann in entsprechender Weise z.B. durch Funktionswerte eine sin-Funktion repräsentiert sein.

Die Breite der Korrekturwerte ist so zu wählen, daß zumindest die Anzahl unterschiedlicher Funktionswerte repräsentiert werden kann, d.h. bei 16 unterschiedlichen Funktionswerten, aus denen ein Korrekturwert ausgewählt wird, beträgt dessen Breite mindestens 4 Bit. Bei 32 unterschiedlichen Funktionswerten betrüge die Breite der Korrekturwert mindestens 5 Bit usw. Die Breite der Korrekturwerte k1, k2 bestimmt wiederum (insbesondere wenn die Wortbreite der Daten der beiden hiermit zu verknüpfenden digitalen Datenströme s1, s2 nur 1 Bit beträgt) die Breite der Werte Ergebnisfolge d und somit indirekt auch der Adresswerte der Adressfolge a.

Die Arithmetikeinheit 5 kann beispielsweise.wie folgt realisiert sein:
- Die Arithmetikeinheit 5 umfaßt zwei Multiplikationseinrichtungen 6, derart daß durch Multiplikation zwei Folgen m1 = s1* k1 und m2 = s2*k2, aus den digitalen Datenströmen s1, s2 und Korrekturwerten k1, k2 der Zuordnungseinheit 4 gebildet werden, wobei die Multiplikation mit den Korrekturwerten k1, k2 jeweils für die einzelnen Daten der Datenströme s1, s2 erfolgt. Anschließend wird in der Additions-/Subtraktionseinheit 7 fortlaufend die Differenz m1 - m2 der beiden Produktfolgen m1, m2 gebildet.
- Bei Bitbreite m = 1 der einzelnen Daten der digitalen Datenströme s1, s2 besteht die Multiplikation in der Multiplikationseinrichtung 6 darin, den Wert der Zuordnungseinheit 4 unbeeinflußt zu lassen, wenn s1 = '1' bzw. s2 = '1' und zu negieren, wenn s1 = '0' bzw. s2 = '0'.
- Bei Bitbreite m = 1 der einzelnen Daten der digitalen Datenströme s1, s2 ergeben sich an den beiden Ausgängen der Sigma-Delta-Modulatoren 3, als Worte aufgefaßt, lediglich vier unterschiedliche Zustände, die unter Einbeziehung der Addition bzw. Subtraktion die Summen und Differenzen der Werte der Zuordnungseinheit 4 und deren Negierte bestimmen. Bei Ablage dieser Werte in der Zuordnungseinheit 4 können damit die Additions- bzw. Subtraktionseinheit und die Zuordnungseinheit 4 vereinfacht werden.

Der Integrierer 9 ist im einfachsten Fall ein Akkumulator. Die Verknüpfungseinheit 8 entfällt bei exakt sinusförmigem Verlauf der eingangsseitigen Analogsignale a1, a2 und einer Phasenlage der Analogsignale von 90° zueinander, da das Gütekriterium k3 = 0 (Phasenablage) wird. Bei anderen Signalverläufen sind Werte der Folge d mit dem Gütekriterium k3 aus der Zuordnungseinheit 4 zu verknüpfen (Addition/Subtraktion). Der Integrierer 9 adressiert direkt die Zuordnungseinheit 4 (z.B. ROM) und nach abschließender Filterung 11 und Zuordnung 12 das Ausgangssignal der Interpolationseinrichtung 2 darstellt.

Im folgenden soll die Wirkung der Interpolationseinrichtung 2 näher beschrieben werden. Die Interpolationseinrichtung 2 wertet die beiden vom Positionsgeber 1 gelieferten, zueinander um 90° phasenverschobenen, sinusähnlichen Analogsignale a1 und a2 (Sinus- bzw. Kosinussignal) so aus, daß das Ausgangssignal w der Interpolationseinrichtung 2 die vom Positionsgeber 1 detektierte Wegänderung repräsentiert. Die vom Positionsgeber 1 gelieferten Analogsignale a1 und a2 werden in den zugehörigen Sigma-Delta-Modulatoren 3 in zwei m-Bit breite Wortfolgen s1, s2 (digitale Datenströme) hoher Frequenz und geringer Wortbreite der Daten gewandelt. Die Amplitudeninformation der Analogsignale a1 und a2 sind am Ausgang dieser Sigma-Delta-Modulatoren 3 in der zeitlichen Verteilung der Daten der beiden digitalen Datenströme s1, s2 enthalten. Die für jeden der beiden Datenströme s1, s2 nachfolgende Multiplikationseinheit 6 bildet aus den Modulatorfolgen s1, s2 und Korrekturwerten k1 und k2 aus der Zuordnungseinheit 4 die neuen Folgen m1 und m2. Aus diesen Folgen m1, m2 wird in der Additions- bzw. Subtraktionseinheit 7 die Ergebnisfolge d erzeugt und mit einem aus der Zuordnungseinheit 4 gewonnenen Gütekriterium verknüpft dem Integrierer 9 zugeführt.

Bei exakt sinusförmigen Verlauf der Eingangssignale a1 und a2 restauriert der Integrierer die Information β = α gemäß sin(α)*cos(β) - cos(α)*sin(β) = sin (α-β), wobei sin(α) und *cos*(*α*) die eingangsseitigen Analogsignale a1, a2 und cos(α) bzw. sin(β) die Korrekturwerte k1 und k2 der Zuordnungseinheit 4 repräsentieren und sin(α-β) dem Phaseninkrement je Abtastung proportional ist.

Andere Umsetzungsfunktionen sind bei andersartigen Eingangssignalen wählbar, um z.B. Fehler des Positionsgebers zu korrigieren. Im Falle sinusförmiger Eingangssignale a1, a2 wird sin(α-β) zur Erreichung des Gütekriteriums minimiert. Mit anderen Worten ausgedrückt ist für α = β das Gütekriterium erfüllt. Ist β der Zählerwert (Adresswert der Zuordnungseinheit 4), dann wird, wenn sin(α -β) = 0, β = α und β entspricht damit der Phasenlage der Eingangssignale.

Zusammenfassend wird die Aufgabe, eine digitale Interpolation zur Erhöhung der Auflösung vorzugsweise inkrementaler Weg- oder Winkelmeßsysteme zu schaffen, vorliegend dadurch verwirklicht, daß zum einen die Vorteile der Sigma-Delta-Modulation bei der Umsetzung analoger Eingangssignale in digitale Datenströme genutzt werden. Das Verfahren der Sigma-Delta-A/D-Umsetzung wurde gewählt, weil der Anteil der analogen Schaltungskomponenten reduziert und im Digitalteil eine hohe Auflösung erreicht werden kann. Durch die Nutzung der geringbittigen Ausgangssignale der Sigma-Delta-Modulatoren als Eingangsinformation für eine Arithmetikeinheit werden arithmetische Operationen, wie z.B. die Multiplikation, stark vereinfacht. Die Bildung nur eines zu bewertenden Kriteriums vereinfacht die digitale Auswerteschaltung (digitaler Filter) weiter und damit auch die Schaltungsintegration.

Die Eigenschaften des Verfahrens ermöglichen es, die nichtlineare A/D-Umsetzung weitgehend in den digitalen Teil der Schaltung zu integrieren, so daß die Interpolationseinrichtung als integrierte Schaltung ausführbar ist. Die bei anderen Verfahren entstehenden Fehler durch nicht ideale analoge Bauelemente werden weitgehend vermieden.

Im einzelnen werden ein Interpolationsverfahren und eine Interpolationseinrichtung zur Signalunterteilung (Interpolation) zweier zueinander um 90° phasenverschobener, sinusförmiger Analogsignale (wahlweise Spannung oder Strom), insbesondere aus inkrementellen Positionsgebern zum Messen von Wegen und/oder Winkeln, vorgeschlagen, bei denen die Analogsignale jeweils mittels Sigma-Delta-Modulation in einen Datenstrom geringer Bitbreite gewandelt werden, bei denen jedes Datum aus den so entstandenen Datenströmen multipliziert wird mit Werten aus einer Zuordnungseinheit, bei denen die Produktwerte der einen Folge mit den Produktwerten der anderen Folge addiert bzw. subtrahiert werden, bei denen die so erzeugte Ergebnisfolge akkumuliert wird und bei denen ein Teil des Akkumulationswertes eine Adressiereinheit so steuert, daß diese Adressiereinheit zum einen die Zuordnungseinheit adressiert und zum anderen über eine Zuordnungseinheit die Ausgangssignale gebildet werden.

Ein wichtiger Vorteil des vorbeschriebenen Verfahrens und der zugehörigen Interpolationseinrichtung besteht darin, daß Verfahrensschritte mit Nachführung und mit "Sigma-Delta-A/D-Umsetzung" miteinander verknüpft werden und dabei auf ein aufwendiges Netzwerk verzichtet wird sowie die Wandlung der Eingangsdaten in Positionswerte in einem Schritt mit ihrer digitalen Wandlung mittels Sigma-Delta-Modulation durchgeführt wird. Durch die Verknüpfung des Prinzips der Nachführung mit der einfachen Sigma-Delta-A/D-Umsetzung reduziert sich der analoge Teil der Interpolationseinrichtung auf ein Minimum und ihr digitaler Teil wird vereinfacht. Es ist möglich, die gesamte Interpolationseinrichtung als eine integrierte Schaltung mit leicht verfügbaren Technologien aufzubauen.

## Patentansprüche

1. Verfahren zur Interpolation mindestens zweier positionsabhängiger, periodischer, zueinander phasenverschobener Analogsignale (a1, a2), die durch Abtastung einer Meßteilung erzeugt werden, bei dem
- die Analogsignale (a1, a2) jeweils mittels eines Sigma-Delta-Modulators (3) in einen digitalen Datenstrom (s1, s2) umgewandelt werden,
- die digitalen Datenströme (s1, s2) in einer Arithmetikeinheit (5) zur Erzeugung einer Ergebnisfolge (d) mit Korrekturfaktoren (k1, k2) sowie anschließend miteinander verknüpft werden und
- aus der Ergebnisfolge (d) einerseits anhand eines bei der Interpolation zu erfüllenden Gütekriteriums (k3) neue Korrekturwerte (k1, k2) und andererseits die Ausgangssignale (w) der Interpolation erzeugt werden,
**dadurch gekennzeichnet,**
**dass** die Werte der Ergebnisfolge (d) zur Erzeugung der neuen Korrekturwerte (k1, k2) sowie der Ausgangssignale (w) in einem Filter (9) über ein vorgebbares Zeitintervall akkumuliert werden und dass die durch Akkumulation erzeugte Adressfolge (a) unmittelbar zur Erzeugung der neuen Korrekturwerte (k1, k2) in einer Zuordnungseinheit (4) und zur Erzeugung der Ausgangssignale (w) in einer Auswerteschaltung (10) verwendet wird.

2. Verfahren nach Anspruch 1, **dadurch gekennzeichnet, daß** die Werte der Ergebnisfolge (d) in einem Filter (9) akkumuliert werden.

3. Verfahren nach Anspruch 2, **dadurch gekennzeichnet, daß** als Filter (9) ein Integrierer verwendet wird.

4. Verfahren nach einem der vorhergehenden Ansprüche, **dadurch gekennzeichnet, daß** durch die Akkumulation eine Adressfolge (a) gebildet wird, deren Adresswerte die Phaseninformation der Analogsignale (a1, a2) repräsentieren.

5. Verfahren nach Anspruch 4, **dadurch gekennzeichnet, daß** aus der Adressfolge (a) durch Tiefpaßfilterung und Zuordnung der Adresswerte die Ausgangssignale (w) der Interpolation erzeugt werden.

6. Verfahren nach Anspruch 4 oder 5, **dadurch gekennzeichnet, daß** die Adresswerte linear abhängig von der Phase der periodischen Analogsignale (a1, a2) sind, wenn das Gütekriterium erfüllt ist.

7. Verfahren nach einem der vorhergehenden Ansprüche, **dadurch gekennzeichnet, daß** die Adresswerte der Adressfolge (a) einen Phasenwert mit fraktionalem Anteil repräsentieren.

8. Verfahren nach Anspruch 7, **dadurch gekennzeichnet, daß** zur Erzeugung der Korrekturwerte (k1, k2) der hochwertige Teil der Adressfolge (a) verwendet wird, der einem ganzzahligen Anteil der Adresswerte entspricht.

9. Verfahren nach Anspruch 7 oder 8, **dadurch gekennzeichnet, daß** zur Erzeugung der Ausgangssignale (w) der Interpolation der hochwertige Teil und der niederwertige Teil der Adressfolge (a) verwendet werden, wobei letzterer dem fraktionalen Anteil der Adresswerte entspricht.

10. Verfahren nach einem der vorhergehenden Ansprüche, **dadurch gekennzeichnet, daß** die Bestimmung der Ausgangssignale (w) der Interpolation rekursiv erfolgt, in dem anhand des Gütekriteriums solange neue Korrekturwerte (k1, k2) erzeugt und mit den Datenströmen (s1, s2) verknüpft werden, bis das Gütekriterium erfüllt ist.

11. Verfahren nach einem der vorhergehenden Ansprüche, **dadurch gekennzeichnet, daß** die möglichen Korrekturwerte (k1, k2) als vorgegebene Werte in einer Zuordnungseinheit (4) abgelegt sind.

12. Verfahren nach Anspruch 11, **dadurch gekennzeichnet, daß** die jeweils mit den Daten der digitalen Datenströme (s1, s2) zu verknüpfenden Korrekturwerte (k1, k2) anhand des Gütekriteriums in Abhängigkeit von den Adresswerten der Adressfolge (a) ausgewählt werden.

13. Verfahren nach einem der vorhergehenden Ansprüche, **dadurch gekennzeichnet, daß** die Korrekturwerte (k1, k2) als Werte einer trigonometrischen Funktion definiert sind.

14. Verfahren nach einem der vorhergehenden Ansprüche, **dadurch gekennzeichnet, daß** die mindestens zwei Analogsignale (a1, a2) um 90° zueinander phasenverschoben sind.

15. Verfahren nach einem der vorhergehenden Ansprüche, **dadurch gekennzeichnet, daß** die Analogsignale (a1, a2) im wesentlichen sinusförmig sind.

16. Verfahren nach einem der vorhergehenden Ansprüche, **dadurch gekennzeichnet, daß** die einzelnen Daten der Datenströme (s1, s2) jeweils multiplikativ mit einem Korrekturfaktor (k1, k2) verknüpft werden und daß die Daten unterschiedlicher Datenströme anschließend durch Addition oder Subtraktion miteinander verknüpft werden.

17. Verfahren nach einem der vorhergehenden Ansprüche, **dadurch gekennzeichnet, daß** die einzelnen Daten der digitalen Datenströme (s1, s2) jeweils eine Wortbreite von einem Bit aufweisen.

18. Verfahren nach Anspruch 16 und 17, **dadurch gekennzeichnet, daß** die Verknüpfung zweier Daten der digitalen Datenströme (s1, s2) mit Korrekturfaktoren (k1, k2) und miteinander reduziert ist zu einer additiven oder subtraktiven Verknüpfung zweier Korrekturwerte.

19. Verfahren nach Anspruch 18, **dadurch gekennzeichnet, daß** die Verknüpfung zusammengefaßt ist zu einer von vier Möglichkeiten der Verknüpfung der Korrekturwerte (k1, k2) durch Addition oder Subtraktion.

20. Einrichtung zur Interpolation mindestens zweier positionsabhängiger, periodischer, zueinander phasenverschobener Analogsignale (a1, a2), die durch Abtastung einer Meßteilung erzeugt wurden, mit
- jeweils einem Sigma-Delta-Modulator (3) zur Umwandlung der Analogsignale (a1, a2) in digitale Datenströme (s1, s2),
- einer Arithmetikeinheit (5) zur Erzeugung einer Ergebnisfolge (d) durch Verknüpfung der digitalen Datenströme (s1, s2) mit Korrekturfaktoren (k1, k2) sowie anschließender Verknüpfung der digitalen Datenströme miteinander und
- Mitteln, mit denen aus der Ergebnisfolge (d) einerseits anhand eines bei der Interpolation zu erfüllenden Gütekriteriums (k3) neue Korrekturwerte (k1, k2) und andererseits die Ausgangssignale (w) der Interpolation erzeugt werden,
**gekennzeichnet durch**
einen Filter (9) zur Akkumulation der Werte der Ergebnisfolge (d) über ein vorgebbares Zeitintervall zur Erzeugung einer Adressfolge (a), der einerseits direkt eine Zuordnungseinheit (4) zur Erzeugung neuer Korrekturwerte (k1, k2) adressiert und damit die Arithmetikeinheit (5) so steuert, dass die Ergebnisfolge (d) zur Erfüllung des Gütekriteriums (k3) geführt wird, und dem andererseits eine die Adresswerte der Adressfolge (a) in die Ausgangswerte (w) der Interpolation umsetzende Auswerteschaltung (10) nachgeschaltet ist.

## Claims

1. Method for interpolating at least two position-dependent, periodic analogue signals (a1, a2) which are phase-shifted relative to each other and are generated by scanning a measuring division, in which
- the analogue signals (a1, a2) are converted respectively into a digital data stream (s1, s2) by means of a sigma-delta modulator (3),
- for generating a result sequence (d), the digital data streams (s1, s2) are combined in an arithmetic unit (5) with correctional factors (k1, k2) and subsequently with each other, and
- from the result sequence (d), there are generated, on the one hand, with reference to a quality criterion (k3) which is to be fulfilled during interpolation, new correctional values (k1, k2) and, on the other hand, the output signals (w) of the interpolation,
**characterised in that**
the values of the result sequence (d) for generating the new correctional values (k1, k2) and also the output signals (w) are accumulated in a filter (9) over a prescribable time interval and **in that** the address sequence (a) generated by accumulation is used directly for generating the new correctional values (k1, k2) in an assignment unit (4) and for generating the output signals (w) in an evaluation circuit (10).

2. Method according to claim 1, **characterised in that** the values of the result sequence (d) are accumulated in a filter (9).

3. Method according to claim 2, **characterised in that** an integrator is used as filter (9).

4. Method according to one of the preceding claims, **characterised in that** an address sequence (a) is formed by accumulation, the address values of which represent the phase information of the analogue signals (a1, a2).

5. Method according to claim 4, **characterised in that**, from the address sequence (a), the output signals (w) of the interpolation are generated by low-pass filtering and assignment of the address values.

6. Method according to claim 4 or 5, **characterised in that** the address values are a linear function of the phase of the periodic analogue signals (a1, a2) when the quality criterion is fulfilled.

7. Method according to one of the preceding claims, **characterised in that** the address values of the address sequence (a) represent a phase value having a fractional component.

8. Method according to claim 7, **characterised in that** the high-value part of the address sequence (a) is used for generating the correctional values (k1, k2), which high-value part corresponds to an integral component of the address values.

9. Method according to claim 7 or 8, **characterised in that** the high-value part and the low-value part of the address sequence (a) are used for generating the output signals (w) of the interpolation, said low-value part corresponding to the fractional component of the address values.

10. Method according to one of the preceding claims, **characterised in that** the determination of the output signals (w) of the interpolation is effected recursively, in which, with reference to the quality criterion, new correctional values (k1, k2) are generated and combined with the data streams (s1, s2) until the quality criterion is fulfilled.

11. Method according to one of the preceding claims, **characterised in that** the possible correctional values (k1, k2) are stored as prescribed values in an assignment unit (4).

12. Method according to claim 11, **characterised in that** the correctional values (k1, k2) which are to be combined respectively with the data of the digital data streams (s1, s2) are selected with reference to the quality criterion as a function of the address values of the address sequence (a).

13. Method according to one of the preceding claims, **characterised in that** the correctional values (k1, k2) are defined as values of a trigonometric function.

14. Method according to one of the preceding claims, **characterised in that** the at least two analogue signals (a1, a2) are phase-shifted by 90° relative to each other.

15. Method according to one of the preceding claims, **characterised in that** the analogue signals (a1, a2) are essentially sinusoidal.

16. Method according to one of the preceding claims, **characterised in that** the individual data of the data streams (a1, a2) are respectively multiplicatively combined with a correctional factor (k1, k2), and **in that** the data of different data streams are subsequently combined with each other by addition or subtraction.

17. Method according to one of the preceding claims, **characterised in that** the individual data of the digital data streams (s1, s2) have a word width of one bit respectively.

18. Method according to claim 16 and 17, **characterised in that** the combination of two items of data of the digital data streams (s1, s2) with correctional factors (k1, k2) and with each other is reduced to an additive or subtractive combination of two correctional values.

19. Method according to claim 18, **characterised in that** the combination is combined to form one of four possibilities of the combination of the correctional values (k1, k2) by addition or subtraction.

20. Device for interpolating at least two position-dependent, periodic analogue signals (a1, a2) which are phase-shifted relative to each other and were generated by scanning a measuring division, having
- a sigma-delta modulator (3) respectively for converting the analogue signals (a1, a2) into digital data streams (s1, s2),
- an arithmetic unit (5) for generating a result sequence (d) by combining the digital data streams (s1, s2) with correctional factors (k1, k2) and also by subsequent combination of the digital data streams with each other, and
- means, with which, from the result sequence (d), there are generated, on the one hand, with reference to a quality criterion (k3) which is to be fulfilled during interpolation, new correctional values (k1, k2) and, on the other hand, the output signals (w) of the interpolation,
**characterised by**
a filter (9), for accumulating the values of the result sequence (d) over a prescribable time interval in order to generate an address sequence (a), which filter, on the one hand, directly addresses an assignment unit (4) for generating new correctional values and hence controls the arithmetic unit (5) such that the result sequence (d) is directed towards fulfilling the quality criterion (k3), and to which, on the other hand, there is subsequently connected an evaluation circuit (10) which converts the address values of the address sequence (a) into the output values (w) of the interpolation.

## Revendications

1. Procédé d'interpolation d'au moins deux signaux analogiques (a1, a2) périodiques, dépendants d'une position, déphasés l'un par rapport à l'autre, qui sont produits par palpage d'une échelle de mesure, selon lequel
- les signaux analogiques (a1, a2) sont chacun convertis à l'aide d'un modulateur sigma-delta (3) en un flux de données numériques (s1, s2),
- les flux de données numériques (s1, s2) sont combinés, dans une unité arithmétique (5), avec des coefficients de correction (k1, k2) pour générer une séquence de résultats (d), et sont ensuite combinés les uns avec les autres, et
- on génère, à partir de la séquence de résultats (d), d'une part de nouvelles valeurs de correction (k1, k2) à l'aide d'un critère de qualité (k3) devant être rempli lors de l'interpolation, et d'autre part les signaux de sortie (w) de l'interpolation,
**caractérisé par le fait que** les valeurs de la séquence de résultats (d) sont accumulées dans un filtre (9) pendant un intervalle de temps prédéfinissable, en vue de générer les nouvelles valeurs de correction (k1, k2) ainsi que les signaux de sortie (w), et **par le fait que** la séquence d'adresses (a) produite par accumulation est utilisée directement pour générer les nouvelles valeurs de correction (k1, k2) dans une unité d'affectation (4) et pour produire les signaux de sortie (w) dans un circuit d'exploitation (10).

2. Procédé selon la revendication 1, **caractérisé par le fait que** les valeurs de la séquence de résultats (d) sont accumulées dans un filtre (9).

3. Procédé selon la revendication 2, **caractérisé par le fait que** l'on utilise un circuit d'intégration en tant que filtre (9).

4. Procédé selon une des revendications précédentes, **caractérisé par le fait que** l'accumulation forme une séquence d'adresses (a) dont les valeurs d'adresse représentent l'information de phase des signaux analogiques (a1, a2).

5. Procédé selon la revendication 4, **caractérisé par le fait que** les signaux de sortie (w) de l'interpolation sont produits à partir de la séquence d'adresses (a), par filtrage passe-bas et affectation des valeurs d'adresse.

6. Procédé selon la revendication 4 ou 5, **caractérisé par le fait que** les valeurs d'adresse présentent une dépendance linéaire vis-à-vis de la phase des signaux analogiques (a1, a2) périodiques, lorsque le critère de qualité est rempli.

7. Procédé selon une des revendications précédentes, **caractérisé par le fait que** les valeurs d'adresse de la séquence d'adresses (a) représentent une valeur de phase avec une partie fractionnaire.

8. Procédé selon la revendication 7, **caractérisé par le fait que** pour générer les valeurs de correction (k1, k2), on utilise la partie de qualité supérieure de la séquence d'adresses (a), qui correspond à une partie en nombres entiers des valeurs d'adresse.

9. Procédé selon la revendication 7 ou 8, **caractérisé par le fait que** pour générer les signaux de sortie (w) de l'interpolation, on utilise la partie de qualité supérieure et la partie de qualité inférieure de la séquence d'adresses (a), cette dernière partie correspondant à la partie fractionnaire des valeurs d'adresse.

10. Procédé selon une des revendications précédentes, **caractérisé par le fait que** la détermination des signaux de sortie (w) de l'interpolation s'effectue de manière récursive, ce qui consiste à générer de nouvelles valeurs de correction (k1, k2) à l'aide du critère de qualité et à les combiner avec les flux de données (s1, s2), jusqu'à ce que le critère de qualité soit rempli.

11. Procédé selon une des revendications précédentes, **caractérisé par le fait que** les valeurs de correction (k1, k2) possibles sont stockées en tant que valeurs prédéfinies dans une unité d'affectation (4).

12. Procédé selon la revendication 11, **caractérisé par le fait que** les valeurs de correction (k1, k2) devant être combinées respectivement avec les données des flux de données numériques (s1, s2) sont sélectionnées à l'aide du critère de qualité, en fonction des valeurs d'adresse de la séquence d'adresses(a).

13. Procédé selon une des revendications précédentes, **caractérisé par le fait que** les valeurs de correction (k1, k2) sont définies en tant que valeurs d'une fonction trigonométrique.

14. Procédé selon une des revendications précédentes, **caractérisé par le fait que** les signaux analogiques (a1, a2), au nombre d'au moins deux, sont déphasés de 90° les uns par rapport aux autres.

15. Procédé selon une des revendications précédentes, **caractérisé par le fait que** les signaux analogiques (a1, a2) sont sensiblement sinusoïdaux.

16. Procédé selon une des revendications précédentes, **caractérisé par le fait que** les différentes données des flux de données (s1, s2) sont combinées respectivement de façon multiplicative avec un coefficient de correction (k1, k2) et que les données de flux de données différents sont ensuite combinées les unes avec les autres par addition ou soustraction.

17. Procédé selon une des revendications précédentes, **caractérisé par le fait que** les différentes données des flux de données numériques (s1, s2) présentent une largeur de mot d'un bit.

18. Procédé selon les revendications 16 et 17, **caractérisé par le fait que** la combinaison de deux données des flux de données numériques (s1, s2) avec des coefficients de correction (k1, k2) et l'une avec l'autre est réduite à une combinaison additive ou soustractive de deux valeurs de correction.

19. Procédé selon la revendication 18, **caractérisé par le fait que** la combinaison se résume dans une possibilité parmi quatre possibilités de combinaison des valeurs de correction (k1, k2) par addition ou soustraction.

20. Dispositif d'interpolation d'au moins deux signaux analogiques (a1, a2) périodiques, dépendants d'une position, déphasés l'un par rapport à l'autre, qui sont produits par palpage d'une échelle de mesure, comprenant
- respectivement un modulateur sigma-delta (3) pour convertir les signaux analogiques (a1, a2) en flux de données numériques (s1, s2),
- une unité arithmétique (5) pour générer une séquence de résultats (d) en combinant les flux de données numériques (s1, s2) avec des coefficients de correction (k1, k2) et en combinant ensuite les flux de données numériques les uns avec les autres, et
- des moyens servant à générer, à partir de la séquence de résultats (d), d'une part de nouvelles valeurs de correction (k1, k2) à l'aide d'un critère de qualité (k3) devant être rempli lors de l'interpolation, et d'autre part les signaux de sortie (w) de l'interpolation,
**caractérisé par le fait qu'**il comprend un filtre (9) pour accumuler les valeurs de la séquence de résultats (d) pendant un intervalle de temps prédéfinissable, en vue de générer une séquence d'adresses (a), lequel filtre adresse d'une part directement une unité d'affectation (4) pour générer de nouvelles valeurs de correction (k1, k2) et commande ainsi l'unité arithmétique (5), de manière à ce que la séquence de résultats (d) soit amenée à répondre au critère de qualité (k3), et est suivi d'autre part d'un circuit d'exploitation (10) convertissant les valeurs d'adresse de la séquence d'adresses (a) en valeurs de sortie (w) de l'interpolation.
